Europäisches Patentamt

European Patent Office

Office européen des brevets

(11) Veröffentlichungsnummer: **0 286 917 B1**

(19)

(12) **EUROPÄISCHE PATENTSCHRIFT**

(45) Veröffentlichungstag der Patentschrift: **02.09.92**

(51) Int. Cl.5: **H01L 31/06**, H01L 31/02

(21) Anmeldenummer: **88105201.3**

(22) Anmeldetag: **30.03.88**

(54) **Solarzelle.**

(30) Priorität: **13.04.87 DE 3712503**

(43) Veröffentlichungstag der Anmeldung:
**19.10.88 Patentblatt 88/42**

(45) Bekanntmachung des Hinweises auf die
Patenterteilung:
**02.09.92 Patentblatt 92/36**

(84) Benannte Vertragsstaaten:
**CH DE ES FR GB IT LI**

(56) Entgegenhaltungen:
EP-A- 0 039 020
EP-A- 0 219 763
GB-A- 2 034 973
US-A- 4 322 571
US-A- 4 367 368

SEVENTH E.C. PHOTOVOLTAIC SOLAR
ENERGY CONFERENCE, PROCEEDINGS OF
THE INTERNATIONAL CONFERENCE, Sevilla,
27.-31. Oktober 1986, Seiten 806-810, D. Reidel Publishing Co., Dordrecht, NL; K. JAE-
GER et al.: "Low temperature back surface
passivation of solar cells by plasma silicon
nitride"

IDEM

(73) Patentinhaber: **Nukem GmbH**
**Industriestrasse 13**
**W-8755 Alzenau(DE)**

(72) Erfinder: **Hackstein, Karl-Gerhard, Dr.**
**Röntgenstrasse 20**
**W-6450 Hanau 1(DE)**
Erfinder: **Hezel, Rudolf, Dr.**
**Ringstrasse 23**
**W-8521 Spardorf(DE)**

(74) Vertreter: **Stoffregen, Hans-Herbert, Dr.**
**Dipl.-Phys.**
**Patentanwalt, Salzstrasse 11 a, Postfach 21**
**44**
**W-6450 Hanau (Main) 1(DE)**

## Beschreibung

Die Erfindung bezieht sich auf eine dünne Solarzelle, insbesondere Dünnschicht-Solarzelle aus einem Halbleitermaterial wie Silizium, gemäß dem Oberbegriff des Anspruchs 1, in deren Halbleitersubstrat durch Strahlungsenergie Minoritäts- und Majoritäts-Ladungsträger erzeugt werden, die durch ein elektrisches Feld trennbar und sodann ableitbar sind, wobei auf einer ersten Halbleitersubstratfläche zueinander beabstandete Ohm'sche Kontakte angeordnet sind, die untereinander verbunden sind, und wobei zumindest zwischen den Ohm'schen Kontakten eine Passivierungsschicht angeordnet ist, die vorzugsweise auch die Ohm'schen Kontakte mit abdeckt. Ferner bezieht sich die Erfindung auch auf ein Verfahren zur Herstellung einer derartigen Solarzelle.

Bei einem Aufbau einer entsprechenden Solarzelle kann die Rekombination von Ladungsträgern im Bereich der Ohm'schen Kontakte reduziert werden, ohne daß eine Potentialschwelle für Minoritätsladungsträger durch Legieren, Diffusion oder Ionenimplantation im Halbleitersubstrat erzeugt werden muß.

Aufgabe der vorliegenden Erfindung ist es daher, eine Solarzelle der eingangs beschriebenen Art so auszubilden, daß die Dicke des Halbleitersubstrats erheblich reduziert werden kann, ohne daß die Gefahr einer erhöhten Rekombination im Bereich der Ohm'schen Kontakte erwächst. Vielmehr soll trotz Reduzierung der Halbleitermaterialdicke die Rekombination im Bereich der Ohm'schen Kontakte weitergehend verringert werden, wobei das Fernhalten von Ladungsträgern von den Ohm'schen Kontakten nicht durch eine Potentialbarriere erfolgt.

Die Aufgabe wird erfindungsgemäß durch die im Kennzeichen des Anspruchs 1 angegebenen Maßnahmen gelöst.

Bei der erfindungsgemäßen Lehre dienen die Ohm'schen Kontakte zur Sammlung der Majoritätsladungsträger und sind direkt auf dem Substratmaterial ohne eine dotierte Zwischenschicht (d.h. ohne spezielle Abschirmung durch eine Potentialbarriere) angebracht. Aufgrund des Fehlens der Potentialbarriere könnten neben den Majoritätsladungsträgern grundsätzlich auch Minoritätsladungsträger zu den Ohm'schen Kontakten gelangen, wenngleich letztere bei idealem Verhalten zum trennenden elektrischen Feld auf der den Ohm'schen Kontakten gegenüberliegenden Seite diffundieren sollten. Um jedoch eine Rekombination von Majoritäts- und Minoritätsladungsträgern im Bereich der Ohm'schen Konktakte zu reduzieren, wird erfindungsgemäß vorgeschlagen, daß die Ohm'schen Kontakte z.B. als schmale Streifen erhöht gegenüber ihrer sehr gut mit einer Isolatorschicht passivierten Umgebung angebracht werden. Hierdurch wird erreicht, daß auch bei sehr dünnen Halbleitersubstraten die Entfernung der Ohm'schen Kontakte von der gegenüberliegenden Minoritätsträger sammelnden Seite relativ groß, vorzugsweise größer als die Diffusionslänge der Minoritätsladungsträger wird, so daß nur wenige Minoritätsladungsträger zu den Ohm'schen Kontakten gelangen können (geringer Konzentrationsgradient in Richtung der Ohm'schen Kontakte). Hierin sind die wesentlichen Unterschiede zum Stand der Technik zu erkennen, auch wenn es bereits bekannt ist, Ohm'sche Kontakte erhaben auszubilden, wie es z.B. in den US-A-4,322,571, US-A-4,367,368 oder die US-A-4,135,950 der Fall ist. Bei den dort beschriebenen Solarzellen sind jedoch die Ohm'schen Kontakte durch eine Potentialbarriere abgeschirmt. Die Ohm'schen Kontakte sind nicht unmittelbar auf das Halbleitersubstrat aufgebracht. Außerdem befindet sich zwischen den Ohm'schen Kontakten keine Passivierungsschicht. Schließlich haben die Ohm'schen Kontakte nach dem Stand der Technik nicht die Aufgabe, die Stabilität von Dünnschicht-Solarzellen zu verbessern, also Zellen, die eine Substratstärke aufweisen, die so dünn ist, daß die Gefahr eines Zerbrechens bestünde.

Mit anderen Worten wird erfindungsgemäß vorgeschlagen, daß die Ohm'schen Kontakte von der durch die Passivierungsschicht (Isolatorschicht) sehr gut passivierten sonstigen Halbleiteroberfläche räumlich getrennt werden. Hierdurch kann außerhalb der Ohm'schen Kontakte eine Halbleitersubstratdicke, die kleiner als die Diffusionslänge der Minoritätsladungsträger ist, gewählt werden, so daß ein hoher Wirkungsgrad der Solarzelle erzielbar ist. Allerdings wird nicht die Rekombination im Bereich der Ohm'schen Kontakte erhöht, da in diesem Bereich der Abstand zu der gegenüberliegenden Seite des Halbleitersubstrats vorzugsweise erheblich größer als die Diffusionslänge der Minoritätsladungsträger ist.

Die Strukturierung der die Ohm'schen Kontakte aufweisenden Halbleiteroberfläche erfolgt vorzugsweise durch selektives Ätzen. Dabei geht man von einer entsprechend dicken Halbleiterscheibe aus, die vorzugsweise stärker als die Diffusionslänge der Minoritätsladungsträger ist. Anschließend bestimmt man die Ohm'schen Kontaktbereiche, um diese durch eine geeignete Ätzmaske abzudecken. Anschließend werden die nicht abgedeckten Bereiche bis zu der gewünschten Dicke des Halbleitersubstrats weggeätzt. Sofern die Ätzmaske nicht gleichzeitig durch das Metall der Ohm'schen Kontakte gebildet wird -hierin ist ein weiteres erfindungsgemäßes Merkmal zu sehen-, wird nach dem Ätzen die Ätzmaske entfernt, um gegebenenfalls das Metall des Ohm'schen Kontaktes aufzubringen. Als Ätzmaske kann z.B. Photolack, $SiO_2$ oder

Si₃N₄ benutzt werden. Es besteht auch die Möglichkeit, daß sich das Metall unter der Ätzmaske befindet.

Bei dem Ätzen selbst kann es sich um isotropes oder anisotropes Ätzen handeln, um chemisches Ätzen oder Plasma-, Ionen-, reaktives Ionen- oder Laserätzen. Besonders vorteilhaft ist die Verwendung des anisotropen Ätzens nämlich dann, wenn man ein (100) orientiertes Silizium benutzt, da bekanntlich die (100) Oberfäche wesentlich schneller geätzt wird als die (111) Fläche. In diesem Falle befinden sich unter der Ätzmaske im Schnitt trapezförmig ausgebildete Bereiche, deren Kantenwinkel 54,7° beträgt. Auf die Spitzen, also die äußeren Stirnflächen dieser Bereiche werden dann die Ohm'schen Kontakte aufgebracht. Als anisotrope Ätzmittel kommen insbesondere die bekannten Strukturätzen auf der Basis von z.B. Kaliumhydroxid oder Äthylendiamin in Frage. Auch (110) Oberflächen können vorteilhafterweise in Verbindung mit dem anisotropen Ätzen verwendet werden, wobei durch senkrechte Wände begrenzte erhabene Bereiche enstehen. Im Schnitt ergibt sich eine Rechteckform.

Vorteilhaft dienen die Ohm'schen Kontakte gleichzeitig als Ätzmaske. Zusammen mit dem Ätzvorgang erfolgt gleichzeitig eine Texturierung der nicht abgedeckten Bereiche zur Erhöhung des Lichteinfalles der mit der Isolatorschicht passivierten Si-Oberfläche.

Zu den Metallen der Ohm'schen Kontakte selbst ist zu bemerken, daß diese z.B. durch Vakuumaufdampfen durch eine mechanische Maske, durch Siebdruck, durch Kathodenzerstäubung aufgebracht und gegebenenfalls mit Photolithograpie strukturiert werden können.

Durch die für die Ohm'schen Kontakte bestimmten erhabenen Bereiche ergibt sich ferner der Vorteil, daß das Halbleitersubstrat stabiler wird, wenngleich zwischen den Erhebungen die Schichtdicke überaus gering ist, ohne daß die Gefahr einer Bruchanfälligkeit erwächst. Dies spielt insbesondere bei der Verwendung von billigerem ein- und polykristallinem ("solar-grade") Siliziummaterial eine große Rolle, das eine geringere Diffusionslänge für die Minoritätsladungsträger besitzt.

Dadurch kann u.a. auch bei diesem Material die von hinten auf die Solarzelle auftreffende Strahlung ausgenützt werden.

Ein weiterer Vorteil der erfindungsgemäßen Ausbildung der Solarzelle besteht darin, daß die Kontaktierung dünner Solarzellen beispielsweise durch Ultraschallschweißen wesentlich erleichtert wird, in dem diese auf den durch die Ohm'schen Kontakte bedeckten dicken Halbleiterbereich bzw. auf einem zusätzlich, aber gleichzeitig mit der Ätzung der Ohm'schen Kontaktbereiche am Rand erzeugten Kontaktierbereich aus dickem Halbleitermaterial ohne Gefahr des Bruches der dünnen Siliziumbereiche erfolgt. Weiterhin erlaubt es diese Anordnung mit einer über den Rand der Solarzelle sich erstreckenden Passivierungsschicht, daß der Vorderseitenkontakt über den Rand zur Rückseite geführt und dort kontaktiert wird. Beide Anschlüsse auf einer Seite zu kontaktieren -z.B. mit Ultraschallvereinfacht wesentlich den Herstellungsprozeß.

Der erfindungsgemäß vorgeschlagene Aufbau der Solarzelle kann für ein- und polykristallines Silizium sowie für Verbindungshalbleiter Verwendung finden.

Ausgestaltungen der Erfindung ergeben sich aus den Ansprüchen und den diesen zu entnehmenden Merkmalen -für sich und/oder in Kombination-.

Weitere Einzelheiten, Vorteile und Merkmale der Erfindung sind der nachfolgenden Beschreibung von in einer Zeichnung dargestellten bevorzugten Ausführungsformen zu entnehmen.

Es zeigen:

Fig. 1    eine erste Ausführungsform einer erfindungsgemäßen Siliziumsolarzelle mit frontseitigen Ohm'schen Kontakten,

Fig. 2    eine Siliziumsolarzelle mit rückseitigen Ohm'schen Kontakten und

Fig. 3    eine weitere Ausführungsform einer Siliziumsolarzelle mit rückseitigen Ohm'schen Kontakten.

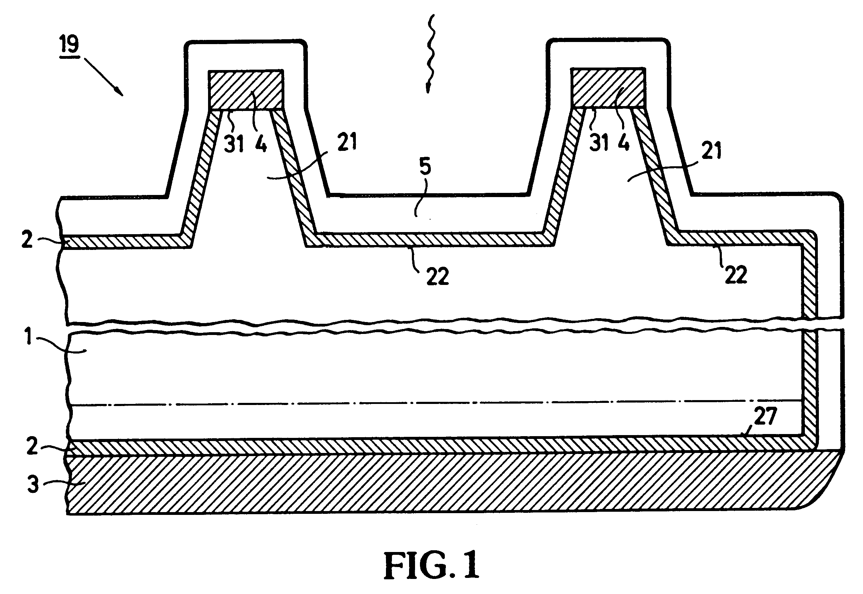

In Fig. 1 ist die Ausführungsform einer erfindungsgemäß aufgebauten Solarzelle (19) dargestellt, die aus einem p-dotierten Siliziumsubstrat als Körper (1), einer dünnen Siliziumoxidschicht (2), Ohm'schen Kontakten (4) sowie einem MIS- (Metal-Insulator-Semiconductor) Kontakt besteht, der sich seinerseits aus dem p-Silizium des Siliziumkörpers (1), der Siliziumoxidschicht (2) und einer Metallisierung (3) vorzugsweise aus Aluminium oder Magnesium oder einer Doppelschicht Mg/Al zusammensetzt. Die Ohm'schen Kontakte (4) sind diskontinuierlich auf dem Halbleitersubstrat (1) angeordnet, wobei diese auf den freien Stirnflächen (31) von Erhebungen (21) angeordnet sind. Hierdurch wird erreicht, daß der Abstand zwischen den Ohm'schen Kontakten und der gegenüberliegenden Seite (27) des Halbleitersubstrats (1) größer als im übrigen Oberflächenbereich des Halbleitersubstrats (1) ist. Dabei ist dieser Bereich mit dem Bezugszeichen (22) versehen. Die Ohm'schen Kontakte (4) können zusammen mit den darunterliegenden erhöhten Siliziumbereichen (21) eine Geometrie bilden, die durch miteinander verbundene Streifen, Ringe oder Punkte zu beschreiben sind.

Zwischen den erhöhten Ohm'schen Kontaktbereichen (4) erstrecken sich Passivierungsschichten, die sich zum einen aus der natürlichen oder auch unterhalb von 800°C erzeugten Siliziumoxidschicht (2) und einer weiteren Isolatorschicht (5) zusammensetzen, die sowohl zur Passivierung wie auch als Antireflektionsschicht dienen kann. Die Dicke der oberen, als erste bezeichnete Passivierungsschicht (5) kann dabei ungefähr 80 nm betragen und besteht vorzugsweise aus Aluminiumoxid oder Siliziumnitrid. Die weitere Isolatorschicht, die als zweite Passivierungsschicht bezeichnet wird, in Form der Siliziumoxidschicht (2) kann auf der Vorder- und Rückseite des Siliziumsubstrats (1) unterschiedlich aufgebaut sein. So kann auf der Vorderseite die Dicke in weiteren Grenzen variiert werden, da sie nicht als Tunnelisolator wirkt. Sie kann dort aber auch vollständig entfallen.

Für die Grenzflächenpassivierung kann sowohl die natürliche Siliziumoxidschicht als auch eine beispielsweise durch thermische oder anders geartete Oxidation speziell präparierte Siliziumoxidschicht (2) verwendet werden. Unter natürlicher Siliziumoxidschicht versteht man diejenige, die stets auf dem Siliziumsubstrat (1) vorhanden ist und nur wenige Atomlagen dick ist.

Die Siliziumoxidschicht (2) selbst kann auf der Vorderseite durch die nachfolgende Abscheidung der ersten Passivierungsschicht (5) -z.B. Siliziumnitrid- in ihrer Strukturzusammensetzung verändert werden. So kann z.B. eine Umwandlung von Siliziumoxid in Siliziumoxynitrid erfolgen.

Anders als bei konventionellen Solarzellen müssen die in der Hauptsache nahe der Frontseite durch das Licht erzeugten Ladungsträger erst durch das ganze Substrat (1) diffundieren, um vom rückseitigen MIS-Kontakt gesammelt zu werden. Dabei ist es äußerst wichtig, daß die Vorderseite, die sich aus dem Bereich der Ohm'schen Kontakte (4) und der durch die Passivierungsschichten (2) und (5) bedeckten Siliziumoberfläche zusammensetzt, eine niedrige Oberflächenrekombinationsgeschwindigkeit besitzt, da andernfalls ein großer Teil der Ladungsträger dort schon rekombinieren würde.

Erfindungsgemäß werden durch einen Silizium-Ätzprozeß die Ohm'schen Kontakte (4) aus der Oberfläche herausgehoben und damit, je nach Höhe der Bereiche, ihr Rekombinationseinfluß mehr oder weniger eliminiert. Durch diese Maßnahme wird nämlich der Abstand der Ohm'schen Kontakte (4) sowohl vom Erzeugungsort der Ladungsträger im Siliziumvolumen (1) wie auch vom sammelnden MIS-Kontakt (3) erheblich vergrößert, so daß die Minoritätsladungsträger wegen des jetzt höheren Konzentrationsgradienten bevorzugt zum MIS-Kontakt diffundieren und dort genutzt werden. Vorteilhafterweise sollte der Abstand der Ohm'schen Kontakte (4) (Fläche (31)) vom gegenüberliegenden MIS-Kontakt (3) (Fläche (27)) größer als die Diffusionslänge der Minoritätsladungsträger sein. Die Dicke des Siliziumsubstrats (1) im Bereich (22) kann größer, gleich oder kleiner, vorzugsweise jedoch erheblich kleiner als die Diffusionslänge sein. Sofern jedoch die Dicke erheblich kleiner als die Diffusionslänge ist, können möglichst viele der an der Oberfläche entstehenden Minoritätsladungsträger zur Rückseite diffundieren, ohne zu rekombinieren. Diese Optimierung von Substratdicke und Höhe der Ohm'schen Kontaktbereiche kann durch die erfindungsgemäße Anordnung unabhängig voneinander durch geeignete Wahl der Ausgangsschichtdicke des Siliziums und durch die Dauer des Ätzprozesses erfolgen. Als weiterer Vorteil ergibt sich, daß die erhabenen Siliziumstege (21) unter dem Ohm'schen Kontakt (4) quasi als mechanische Verstärkung für das Siliziumvolumen (1) dienen. Dieses muß, um insbesondere für billiges Solarsilizium (geringe Diffusionslänge) hohe Wirkungsgrade zu gewährleisten, möglichst dünn sein (bis herab zu 10 $\mu$m), was ohne die mechanisch stabileren Ohm'schen Kontaktbereiche nicht zu realisieren ist -zumindest nicht auf größeren Flächen. Dadurch wird die Herstellung von Solarzellen auf dünnstem Silizium auch großtechnisch ermöglicht. Weiterhin kann gleichzeitig mit dem Ätzen (anisotropes Ätzen) die Texturierung der Siliziumoberfläche zur Erhöhung des Lichteinfalls erfolgen.

Die Ohm'schen Kontakte (4) sind vorzugsweise in Fingerform angeordnet, d. h., sie setzen sich aus parallel zueinander verlaufenden Stegen zusammen, die an einer Seite miteinander verbunden sind (Kammform). Dabei soll der Abstand der Ohm'schen Kontaktfinger untereinander wesentlich größer sein als die Dicke d (Abstand zwischen Flächen (22) und (27)) des Siliziumsubstrats (1) bzw. als die Diffusionslänge der Minoritätsladungsträger, so daß im Mittel der Weg zum sammelnden MIS-Kontakt geringer ist als zu dem Ohm'schen Kontaktbereich. Nach oben ist der Abstand der Ohm'schen Kontakte (4) durch den Serienwiderstand begrenzt. Der optimale Abstand liegt im Bereich von 1 bis 5 mm, die Fingerbreite im Bereich von 50 bis 300 $\mu$m, wodurch sich ein Kontaktflächenanteil bzw. eine Abschattung von weniger als 10% erreichen läßt.

Das rückseitige Metall (3) des MIS-Kontaktes dient als Reflektor für das nicht absorbierte Licht, so daß dadurch der Lichtweg im Silizium und damit die Erzeugung von Ladungsträgern wesentlich erhöht wird, was insbesondere den vorteilhaften Einsatz von sehr dünnem billigem Solarsilizium ermöglicht. Außerdem führt die Reflektion des infraroten Anteils des Sonnenlichtes an der Rückseite zu einer geringeren Aufheizung der Solarzelle und damit zu einem höheren Wirkungsgrad unter realen Betriebsbedingungen.

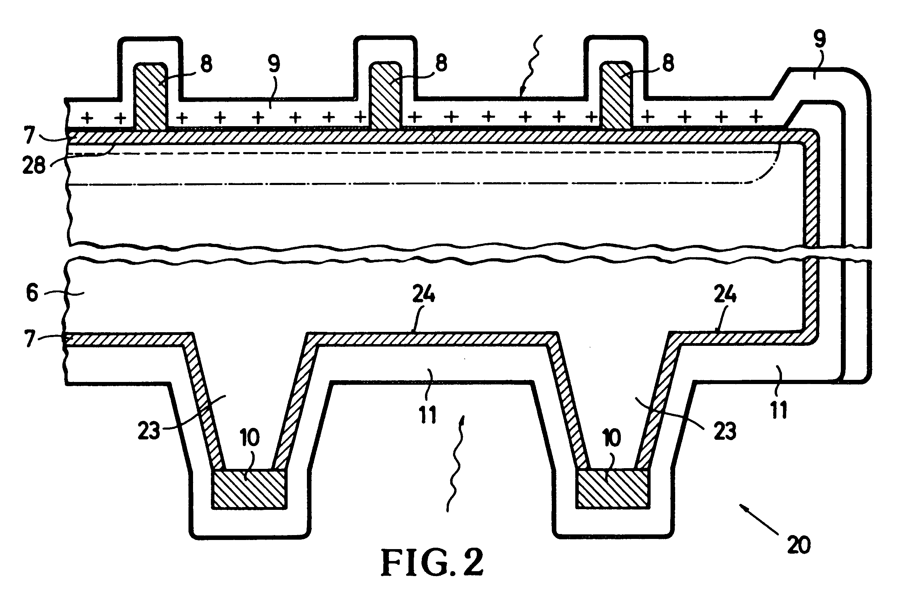

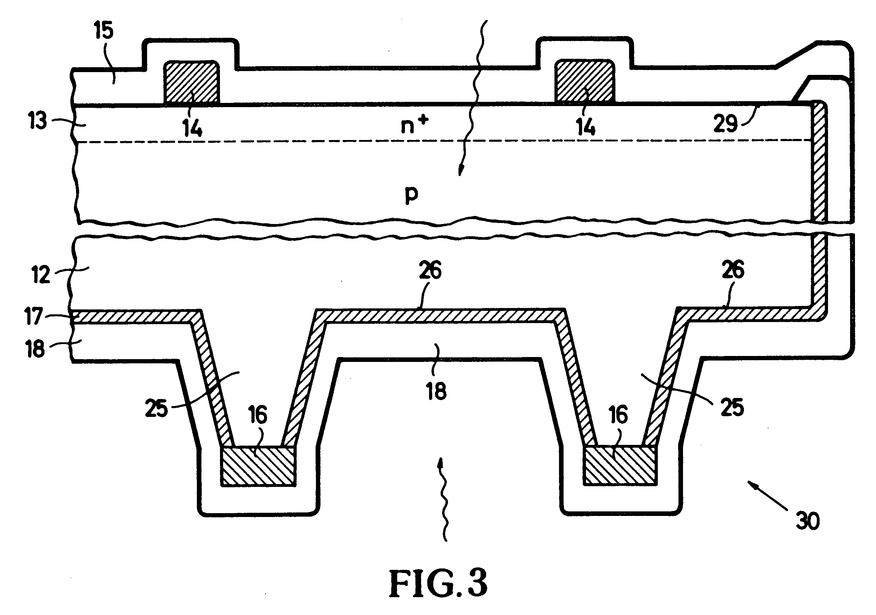

In den Fig. 2 und 3 sind weitere Ausgestaltungen von Solarzellen (20) bzw. (30) dargestellt, die der erfindungs-gemäßen Lehre gehorchen. Dabei ist der jeweilige Ohm'sche Kontakt (10) bzw. (16) auf der Rückseite der Solarzelle (20) bzw. (30) angeordnet, und zwar unmittelbar auf dem Halbleitersubstratkörper (6) bzw. (21) und ebenfalls bereichsweise, wie es auch schon in Fig. 1 der Fall war.

Die in Fig. 2 dargestellte Solarzelle (20) entspricht dem grundsätzlichen Aufbau nach der in der DE-C-2 846 096 beschriebenen Siliziumnitrid-Inversionsschicht-Solarzelle mit MIS-Kontakten. Die Solarzelle (20) weist ein p-Siliziumsubstrat bzw. -körper (6) auf, auf dem eine dünne Siliziumoxidschicht (7) angeordnet ist. Frontseitig sind MIS-Kontakte angeordnet, die sich aus dem Halbleitersubstrat (6), der Siliziumoxidschicht (7) und diskontinuierlich von vorzugsweise in Streifenform angeordneten Metallschichten (8) zusammensetzt. Über die aus Bereichen der Siliziumoxidschicht (7) und den Metallstreifen (8) gebildeten Oberfläche erstreckt sich sodann eine weitere Isolatorschicht (9), die vorzugsweise aus Siliziumnitrid besteht. In der Siliziumnitridschicht (9), und zwar an der Nitrid-Oxid-Grenzschicht befindet sich eine ortsfeste, positive Flächenladung, bestehend aus den natürlichen Ladungen und den durch Fremdionen eingebrachten, die an der Oberfläche des p-dotierten Siliziumsubstrats (6) eine aus Elektronen bestehende Inversionsschicht induziert. Die durch das Licht erzeugten Elektronen (Minoritätsladungsträger) diffundieren zur Vorderseite und werden dort in dem durch die positiven Isolatorladungen erzeugten elektrischen Feld beschleunigt und wandern entlang der gut leitenden Inversionsschicht zu den MIS-Kontakten, durch die sie den Siliziumkörper (6) verlassen und in einen äußeren Stromkreis gelangen. Die Majoritätsladungsträger, also Löcher im p-Siliziumkörper (6) diffundieren zu den Ohm'schen Kontakten (10).

Ferner ist eine weitere Passivierungsschicht (11) vorgesehen, die auch die Ohm'schen Kontakte (10) abdeckt. Als ausschlaggebende Ausbildung ist sodann festzustellen, daß die Ohm'schen Kontakte (10) erhaben angeordnet sind, d.h. auf von der normalen Oberfläche (24) sich erhebenden vorzugsweise streifenförmig ausgebildeten Vorsprüngen (23), die durch einen Siliziumätzprozeß entstehen. Hierdurch bedingt wird der Einfluß der Ohm'schen Kontakte (10) auf die Rekombination der Ladungsträger stark reduziert bzw. bei Abständen vom Entstehungsort, die erheblich größer sind als die Diffusionslänge, völlig eliminiert. Damit kann das eigentliche Siliziumsubstrat (6) dünner gemacht werden, ohne die Rekombination zu erhöhen. Dadurch wird sowohl der Wirkungsgrad in bezug auf das von vorne wie auch auf das von hinten einfallende Licht wesentlich erhöht.

Insbesondere gilt auch hier der entscheidende Vorteil, daß die mechanische Stabilität des dünnen Siliziumsubstrats (6) durch die Siliziumerhebungen oder -streben (23) unterhalb des Ohm'schen Kontaktes (10) wesentlich verbessert und damit die wirtschaftliche Herstellung hocheffizienter extrem dünner (d <50μm) doppelseitig beleuchtbarer Siliziumsolarzellen erst ermöglicht wird. Es ist besonders anzumerken, daß dies ohne wesentlichen zusätzlichen technologischen Aufwand erfolgt.

Auch hier kann durch Anwendung eines anisotropen Ätzmittels und (100) oder (110) orientiertem Silizium eine Texturierung der Rückseite gleichzeitig mit der Ätzung der Kontaktbereiche (10) erfolgen. Die Abstände der MIS-Kontakte auf der Vorderseite (50 μm - 1 mm) sind wesentlich kleiner als die Abstände der Ohm'schen Kontakte auf der Rückseite (1 mm - 5 mm).

Zur Passivierung der Rückseite mittels der durchsichtigen Passivierungs- oder Isolatorschicht (11) kommt vorzugsweise Siliziumnitrid bzw. Siliziumoxynitrid (im Plasma hergestellt) oder Aluminiumoxyd bzw. Aluminiumoxynitrid in Frage. Die Herstellungstemperaturen liegen zwischen 300°C und 600°C. Die Funktion dieser Schichten auf der Rückseite ist aber gänzlich verschieden von der auf der Vorderseite. Bei letzterer müssen hohe positive Ladungen an der Grenzfläche vorhanden sein, damit, eine gut leitende Inversionsschicht (Elektronengas) dicht unter der Oberfläche erzeugt wird. Auf der Rückseite hingegen muß die Oberflächenrekombinationsgeschwindigkeit stark vermindert werden; eine gut leitende Inversionsschicht ist hier eher schädlich, da sie die Minoritätsladungsträger zu den Ohm'schen Kontakten hin leitet, wo sie rekombinieren und damit einer Nutzung verlorengehen. Die rückseitige Siliziumnitridschicht (11) wird bei höheren Temperaturen hergestellt im Vergleich zu der auf der Vorderseite vorhandenen Nitridschicht (9). Es ist aber trotzdem vorteilhaft, auch die positive Ladungsdichte in der rückseitigen Nitridschicht (11) durch Einbau von Fremdionen (insbesondere Alkaliionen) zu erhöhen, da damit zwar nicht die Dichte der Oberflächenzustände, sondern ihre elektrische Aktivität als Rekombinationszentren vermindert wird. Man reduziert also dadurch zusätzlich zu der während der Nitridabscheidung bzw. Nachtemperung erfolgenden Wasserstoffpassivierung die Oberflächenrekombination. Die durch die hohen Ladungsdichten entstehende bzw. in ihrer Leitfähigkeit stark erhöhte Inversionsschicht nimmt man dadurch in Kauf.

Die vorliegende Erfindung mit den durch Ätzung zurückgesetzten Ohm'schen Kontakten (10) jedoch reduziert auch den nachteiligen Einfluß der Inversionsschicht ganz erheblich, indem bei gleichbleibendem Abstand der Ohm'schen Kontakte untereinander die Länge der Inversionsschicht und damit deren Widerstand erheblich vergrößert und damit ein Abfließen der Minoritätsladungsträger zu den Ohm'schen Kontakten stark eingeschränkt wird. Insofern läßt sich mit dieser verbesserten Anordnung der Rückseitenkontakte (10) durch höhere Isolatorladungsdichten die Rekombination weiter herabsetzen, ohne den zusätzlichen Nachteil bezüglich der Inversionsschicht in Kauf nehmen zu müssen. Dieser Vorteil gilt auch für die in Fig. 1 angeführte Solarzelle mit dem erhabenen Ohm'schen Kontaktgitter auf der Vorderseite. Aluminiumoxid als Isolatorschicht (11) enthält negative Ladungen, die auf p-Silizium zu einer Anreicherung von Löchern an der Siliziumoberfläche führen. Dort tritt vorteilhafterweise das Problem mit der Inversionsschicht überhaupt nicht auf, die Elektronen als Minoritätsladungsträger werden durch die Potentialbarriere von der Rückseite abgestoßen.

Will man die von der Rückseite auffallende Strahlung nicht ausnutzen, so kann man wahlweise auf die durchsichtige Isolatorschicht (11) über die gesamte Rückseite ein gut reflektierendes Metall (z.B. Al, Ag), beispielsweise durch Vakuumaufdampfen oder Kathodenzerstäubung, aufbringen. Dadurch wird durch Reflektion der Weg des von vorne einfallenden Lichtes im Silizium verdoppelt und damit, insbesondere für dünnes billiges Solarsilizium, der Wirkungsgrad erhöht.

Fig. 3 stellt eine der erfindungsgemäßen Lehre gehorchende Solarzelle (30) dar, bei der es sich um eine konventionelle $n^+p$ oder $p^+n$-Solarzelle handeln kann.

Die im Ausführungsbeispiel dargestellte $n^+p$-Solarzelle (30) umfaßt ein Halbleitersubstrat (12), eine hochdotierte Oberflächenschicht (13) (hier $n^+$), auf der Vorderseite einen nicht flächig angeordneten Ohm'schen Kontakt (14) in Form eines Gitters und eine vorderseitige Antireflektionsschicht (15). Auf der Rückseite befinden sich ebenfalls nichtflächig angeordnete, vorzugsweise steg- oder gitterförmig ausgebildete Ohm'sche Kontakte (16) und Passivierungsschichten vorzugsweise in Form einer Siliziumoxidschicht (17) und einer auch als Antireflektionsschicht wirkenden Isolierschicht (18). Dabei wird die Isolierschicht (18) vorzugsweise aus Aluminiumoxid oder Siliziumnitrid gebildet. Durch die rückwärtige Ausbildung der $n^+p$-Solarzelle (30) wird auf einfache Weise eine beidseitig beleuchtbare Solarzelle mit dem zusätzlichen Vorteil zur Verfügung gestellt, daß jeweils die langwellige Wärmestrahlung aus der Zelle (30) austritt und damit die Betriebstemperatur sinkt (Erhöhung der Leerlaufspannung). Vorzugsweise sind nun die Ohm'schen Kontakte (16) in Form von Fingern auf Erhebungen (25) angeordnet, die durch Siliziumätzung aus der Oberfläche (26) herausgehoben werden. Dabei sind die Ohm'schen Kontakte (16) erkennbar von der Passivierungsschicht (18) überzogen.

Durch die erfindungsgemäße Ausbildung der Solarzelle (30) werden die gleichen Vorteile erreicht wie bei der Solarzelle (20) nach Fig. 2. Ein Unterschied beider Zellen (20) und (30) liegt jedoch darin, daß die Solarzelle (30) mit pn-Übergang Hochtemperaturprozesse enthielt, während die gesamte Solarzelle (20) durch einfache Niedertemperaturprozesse hergestellt wird. Beide Solarzellen können sowohl die auf die Vorderseite wie auch die auf die Rückseite auftreffende Sonnenstrahlung ausnutzen. Wahlweise kann auch auf die Rückseite ein reflektierendes Metall aufgebracht werden.

Selbstverständlich sind die zuvor beschriebenen Merkmale auch bei einer Solarzelle mit n-dotiertem Siliziumsubstrat gegeben.

## Patentansprüche

1. Dünne Solarzelle (19, 20, 30), insbesondere Dünnschicht-Solarzelle, in deren Halbleitersubstrat (1, 6, 12, 13) durch Strahlungsenergie Minoritäts- und Majoritätsladungsträger erzeugt werden, die durch ein elektrisches Feld trennbar und sodann ableitbar sind, wobei auf einer ersten Halbleitersubstratfläche zueinander beabstandete Ohm'sche Kontakte (4, 10, 16) angeordnet sind, die untereinander verbunden sind, und wobei zumindest zwischen den Ohm'schen Kontakten eine Passivierungsschicht (5, 11, 18) angeordnet ist, die vorzugsweise auch die Ohm'schen Kontakte abdeckt, **dadurch gekennzeichnet,** daß das die Minoritäts- und Majoritätsladungsträger trennende elektrische Feld im Bereich der zweiten Halbleitersubstratfläche (27, 28, 29) verläuft, die der die Ohm'schen Kontaktbereiche aufweisenden ersten Halbleitersubstratfläche gegenüberliegt, so daß die Majoritätsladungsträger zu den Ohm'schen Kontaktbereichen diffundieren und von diesen gesammelt werden, und daß die Ohm'schen Kontakte (4, 10, 16) direkt, d.h. ohne eine dotierte zwischenschicht auf ersten Bereichen (21, 23, 25) der ersten Halbleitersubstratfläche angeordnet sind, die gegenüber zwischen den Ohm'schen Kontakten vorhandenen zweiten Bereichen (22, 24, 26) des Halbleitersubstrats erhaben sind.

2. Solarzelle nach Anspruch 1, **dadurch gekennzeichnet,** daß das die Minoritäts- und Majoritätsladungsträger trennende elektrische Feld durch auf der zweiten Substratkörperfläche ausgebildete MIS-Kontakte (6, 7, 8) in Verbindung mit einer elektrische Ladungen enthaltenden Isolierschicht (9) erzeugt wird.

3. Solarzelle nach zumindest Anspruch 1, **dadurch gekennzeichnet,**

daß der Abstand zwischen den Ohm'schen Kontakten (4, 10, 16) und der gegenüberliegenden Seite (27, 28, 29) des Halbleitersubstrats (1, 6, 12) größer als die Diffusionslänge der Minoritätsladungsträger ist.

4.  Solarzelle nach zumindest Anspruch 1,
    **dadurch gekennzeichnet,**
    daß der Abstand zwischen der Außenfläche der zweiten Bereiche (22, 24, 26) und der gegenüberliegenden Seite (27, 28, 29) des Halbleitersubstrats (1, 6, 12) kleiner, vorzugsweise erheblich kleiner als die Diffusionslänge der Minoritätsladungsträger ist.

5.  Solarzelle nach zumindest Anspruch 1,
    **dadurch gekennzeichnet,**
    daß die die Stabilität des Halbleitersubstrats (1, 6, 12, 13) wesentlich bestimmenden erhabenen ersten Bereiche (21, 23, 25) im Querschnitt trapezförmig, rechteckförmig oder gekrümmt ausgebildet sind.

6.  Solarzelle nach zumindest Anspruch 1,
    **dadurch gekennzeichnet,**
    daß die erhabenen ersten Bereiche (21, 23, 25) mit den auf deren äußeren Stirnflächen (31) angeordneten Ohm'schen Kontakten (4, 10, 16) in Draufsicht eine Kamm-, Gitter- oder Ringstruktur aufweisen.

7.  Solarzelle nach Anspruch 6,
    **dadurch gekennzeichnet,**
    daß die Ringstruktur durch konzentrisch verlaufende Ringe mit radial verlaufenden Bahnen gebildet ist.

8.  Solarzelle nach zumindest Anspruch 1,
    **dadurch gekennzeichnet,**
    daß das Halbleitersubstrat (1, 6, 12) einkristallines (100) oder (110) orientiertes Silizium oder polykristallines Silizium oder ein Verbindungshalbleiter ist.

9.  Solarzelle nach zumindest Anspruch 1,
    **dadurch gekennzeichnet,**
    daß die ersten und/oder zweiten Bereiche (21, 22, 23, 24, 25, 26) zumindest außerhalb der Ohm'schen Kontakte (4, 10, 16) texturiert sind.

10. Solarzelle nach zumindest Anspruch 1,
    **dadurch gekennzeichnet,**
    daß der Abstand der Ohm'schen Kontakte (4, 10, 16) untereinander größer als der Abstand zwischen den zweiten Bereichen (22, 24, 26) und der diesen gegenüberliegenden Seite (27, 28, 29) des Halbleitersubstrats (1, 6, 12) ist.

11. Solarzelle nach Anspruch 10,
    **dadurch gekennzeichnet,**
    daß die Ohm'schen Kontakte (4, 10, 16) in Draufsicht eine Fingerstruktur zeigen, wobei der Abstand zwischen den Fingern zwischen 1 mm und 5 mm bei einer Breite der Finger von 50 $\mu$m bis 300 $\mu$m beträgt.

12. Solarzelle nach Anspruch 2 in Form einer Siliziumnitrid-Inversionsschicht-Solarzelle (20) mit den Ohm'schen Kontakten (10) gegenüberliegenden MIS-Kontakten (6, 7, 8),
    **dadurch gekennzeichnet,**
    daß der Abstand zwischen den sequentiell vorhandenen Metallschichten (8) der MIS-Kontakte (6, 7, 8) bis zu 1/50, vorzugsweise 1/20 bis 1/2 geringer als der zwischen den Ohm'schen Kontakten (10) ist.

13. Solarzelle nach Anspruch 12,
    **dadurch gekennzeichnet,**
    daß der Abstand zwischen den Metallschichten (8) zwischen 50 $\mu$m und 1 mm und der der Ohm'schen Kontakte (10) zwischen 1 mm und 5 mm liegt.

14. Verfahren zur Herstellung einer dünnen Solarzelle gemäß Anspruch 1,
    **dadurch gekennzeichnet,**
    - daß auf einer Seite einer Halbleitersubstratscheibe eine Maske aufgebracht wird, die die Ohm'schen Kontaktbereiche bestimmt,
    - daß durch Ätzen von der Maske nicht abgedeckte Bereiche bis zu der gewünschten Dicke des Halbleitersubstrats weggeäztzt werden, und
    - daß die gesamte Seite des Halbleitersubstrats mit einer Passivierungsschicht abgedeckt wird.

15. Verfahren nach Anspruch 14,
    **dadurch gekennzeichnet,**
    daß als Maske ein die Ohm'schen Kontakte bildendes elektrisch leitendes Material verwendet wird.

16. Verfahren nach Anspruch 14,
    **dadurch gekennzeichnet,**
    daß nach Ätzen der durch die Maske nicht abgedeckten Bereiche die Maske entfernt wird und auf die nicht weggeätzten Bereiche zur Bildung der Ohm'schen Kontakte ein elektrisch leitendes Material aufgebracht wird.

17. Verfahren nach Anspruch 14,
    **dadurch gekennzeichnet,**
    daß die durch die Masken nicht abgedeckten Bereiche vorzugsweise gleichzeitig mit dem Ätzen texturiert werden.

18. Verfahren nach Anspruch 14,
**dadurch gekennzeichnet,**
daß als Halbleitersubstrat einkristallines (100) oder (110) orientiertes Silizium verwendet wird und das Ätzen durch anisotrope Ätzmittel wie Kaliumhydroxid oder Äthylendiamin erfolgt.

19. Verfahren nach Anspruch 14,
**dadurch gekennzeichnet,**
daß als Halbleitersubstrat einkristallines Silizium verwendet wird und das Ätzen durch isotrope Ätzmittel erfolgt.

20. Verfahren nach Anspruch 14,
**dadurch gekennzeichnet,**
daß die Passivierungsschicht bei einer Temperatur zwischen 300°C und 600°C auf das Halbleitersubstrat aufgebracht und/oder in diesem Bereich getempert wird.

21. Verfahren nach Anspruch 20,
**dadurch gekennzeichnet,**
daß auf die Passivierungsschicht vorzugsweise durch Vakuumaufdampfen oder Kathodenzerstäubung oder in Form einer Metallfolie eine Reflektionsschicht aufgebracht wird.

22. Verfahren nach Anspruch 14,
**dadurch gekennzeichnet,**
daß das Ätzen polykristallinen Siliziums als Halbleitersubstrat durch isotrope oder anisotrope Ätzmittel erfolgt.

**Claims**

1. A thin solar cell (19, 20, 30), especially a thin-film solar cell, in whose semiconductive substrate (1, 6, 12, 13) minority and majority charge carriers are generated by radiation energy, said charge carriers being separatable and so dischargeable by an electrical field, having a first semiconductive substrate surface upon which are arranged at intervals ohmic contacts (4, 10, 16) being interlinked with one another, and a passivation layer (5, 11, 18) is arranged at least between said ohmic contacts, **characterized in that,** the electrical field separating the minority and majority charge carriers exists in tie vicinity of the second semiconductive substrate surface (27, 28, 29) positioned opposite the first semiconductive substrate surface carrying the ohmic contact zones, so that the majority charge carriers diffuse to the ohmic contact zones which collect said charge carriers, and that the ohmic contacts (4, 10, 16) are arranged directly on the fist zones (21, 23, 25) of the first semiconductive substrate surface, i.e., without a doped region, said semiconductive substrate surface being elevated in relation to existing second zones (22, 24, 26) lying between the ohmic contacts.

2. A solar cell according to Claim 1,
**characterized in that,**
the electrical field separating tie minority and majority charge carriers is generated by MIS contacts (6, 7, 8) formed on the second substrate surface in conjunction with an insulating lamina (9) containing electrical charges.

3. A solar cell according at least to Claim 1,
**characterized in that,**
the distance separating the ohmic contacts (4, 10, 16) and the opposite side (27, 28, 29) of the semiconductive substrate (1, 6, 12) is greater than the diffusion length of the minority charge carriers.

4. A solar cell according at least to Claim 1,
**characterized in that,**
the distance separating the outer surface of the second area (22, 24, 26) and the opposite side (27, 28, 29) of the semiconductive substrate (1, 6, 12) is smaller, preferably considerably smaller, than the diffusion length of the minority charge carriers.

5. A solar cell according at least to Claim 1,
**characterized in that,**
the elevated first areas (21, 23, 25) essentially determining the stability of the semiconductive substrate (1, 6, 12, 13) are trapeziodal, rectangular or curved in cross-section.

6. A solar cell according at least to Claim 1,
**characterized in that,**
the elevated first areas (21, 23, 25) with tie ohmic contacts (4, 10, 16) arranged on their peaks (31) exhibit a comb, grid or ring structure when viewed in plan.

7. A solar cell according to Claim 6,
**characterized in that,**
the ring structure is formed by concentrically arranged rings with radially running paths.

8. A solar cell according at least to Claim 1,
**characterized in that**
the semiconductive substrate (1, 6, 12) is a singlecrystalline (100)- or(110)-orientated silicon or polycrstalline silicon or compound semiconductive.

9.  A solar cell according at least to Claim 1,
    **characterized in that,**
    the first and/or second areas (21, 22, 23, 24, 25, 26) are textured at least outside the ohmic contacts (4, 10, 16).

10. A solar cell according at least to Claim 1,
    **characterized in that,**
    the distance between the ohmic contacts (4, 10, 16) is greater than the distance between the second areas (22, 24, 26) and the side (27, 28, 29) of semiconductive substrate (1, 6, 12) opposite thereto.

11. A solar cell according to Claim 10,
    **characterized in that,**
    the ohmic contacts (4, 10, 16) when viewed in plan exhibit a finger-like structure, whereby the spacing between the fingers lies between 1 nm and 5 mm, the width of said fingers being 50 $\mu$m to 300 $\mu$m.

12. A solar cell according to Claim 2 in the form of a silicon nitride inversion layer solar cell (20) with MIS contacts (6, 7, 8) lying opposite the ohmic contacts (10),
    **characterized in that,**
    the distance separating the sequentially existing metal layers (8) of the MIS contacts (6, 7, 8) is up to 1/50 less than that between the ohmic contacts (10), and preferably 1/20 to 1/2.

13. A solar cell according to Claim 12,
    **characterized in that,**
    the distance separating tie metal layers (8) lies between 50 $\mu$m and 1 mm, and that between the ohmic contacts (10) between 1 mm and 5 mm.

14. A method of producing a thin solar cell according to claim 1,
    **characterized in that,**
    - a mask is applied on one side of a semiconductive substrate wafer, said mask defining the ohmic contact zones,
    - zones not covered by said mask are etched to the desired thickness of the semiconductive substrate,
    - the complete side of the semiconductive substrate is covered with a passivation layer.

15. A method according to Claim 14,
    **characterized in that,**
    an electrical conductive material forming the ohmic contacts is used as the aforesaid mask.

16. A method according to Claim 14,
    **characterized in that,**
    after etching the zones not covered by the mask, said mask is removed, and an electrical conductive material applied to the non-etched zones to form, the ohmic contacts.

17. A method according to Claim 14,
    **characterized in that,**
    the zones left uncovered by the mask are preferably textured simultaneously with the etching operation.

18. A method according to Claim 14,
    **characterized in that,**
    single-crystalline (110)- or (110)-orientated silicon is used as the semiconductive substrate, aid that etching is undertaken with anisotropic etching material such as potassium hydroxide or ethylene diamine.

19. A method according to Claim 14,
    **characterized in that,**
    single-crystalline silicon is used as the semiconductive substrate, and that etching is undertaken with isotropic etching material.

20. A method according to Claim 14,
    **characterized in that,**
    the passivation layer is deposited at a temperature of between 300°C and 600°C on the semiconductive substrate and/or tempered in this range.

21. A method according to Claim 20,
    **characterized in that,**
    the passivation layer is applied preferably by vacuum evaporation or cathode sputtering or a reflective layer applied in the form of a metal foil.

22. A method according to Claim 14,
    **characterized in that,**
    etching of the polycrystalline silicon as semiconductive substrate is done with isotropic or anisotropic etching material.

**Revendications**

1.  Cellule solaire mince (19, 20, 30), essentiellement éléments à couche mince de cellule solaire, dans le substrat semiconducteur (1, 6, 12, 13) desquels des porteurs de charge minoritaires et majoritaires sont générés et qui sont séparables par un champ électrique et ensuite dérivables, des contacts ohmiques (4, 10, 16) étant disposés avec un certain écart entre eux sur une première surface de substrat semiconducteur et une couche de passivation (5, 11, 18) étant logée au moins entre les contacts ohmiques qui recouvre de préférence également les contacts ohmiques, **caractérisée en ce que** le champ électrique séparant les porteurs de charge minoritaires et majoritaires se situe dans la zone du deuxième substrat semiconducteur (27, 28, 29) opposé à la première surface de substrat semiconducteur présentant les zones de contact ohmiques, de sorte que les porteurs de charge majoritaires sont diffusés vers les zones de contact ohmiques et y sont collectés et que les contacts ohmiques (4, 10, 16) sont disposés directement, c.-à-d. sans couche intermédiaire dopée, sur des premières zones (21, 23, 25) de la première surface de substrat semiconducteur qui sont exhaussées par rapport aux deuxièmes zones (22, 24, 26) du substrat semiconducteur se trouvant entre les contacts ohmiques.

2. Cellule solaire selon la revendication 1 **caractérisée en ce que** le champ électrique séparant les porteurs de charge minoritaires et majoritaires est généré par des contacts MIS (6, 7, 8) formés sur la deuxième surface de substrat en liaison avec une couche isolante (9) contenant des charges électriques.

3. Cellule solaire selon au moins la revendication 1, **caractérisée en ce que** l'écart entre les contacts ohmiques (4, 10, 16) et le côté opposé (27, 28, 29) du substrat semiconducteur (1, 6, 12) est plus grand que la longueur de diffusion des porteurs de charge minoritaires.

4. Cellule solaire selon au moins la revendication 1, **caractérisée en ce que** l'écart entre la surface extérieure des deuxièmes zones (22, 24, 26) et le côté opposé (27, 28, 29) du substrat semiconducteur (1, 6, 12) est plus petit, de préférence beaucoup plus petit que la longueur de diffusion des porteurs de charge minoritaires.

5. Cellule solaire selon au moins la revendication 1, **caractérisée en ce que** les premières zones (21, 23, 25) exhaussées déterminant essentiellement la stabilité du substrat semiconducteur (1, 6, 12, 13) sont de section tapézoïdale, rectangulaire ou courbées.

6. Cellule solaire selon au moins la revendication 1, **caractérisée en ce que** les premières zones exhaussées (21, 23, 25) présentent avec les contacts ohmiques (4, 10, 16) disposés sur les surfaces frontales externes (31) une structure de peigne, de grille ou annulaire en vue de dessus.

7. Cellule solaire selon au moins la revendication 6, **caractérisée en ce que** la structure annulaire est formée par des anneaux concentriques avec des lignes radiales.

8. Cellule solaire selon au moins la revendication 1, **caractérisée en ce que** le substrat semiconducteur (1, 6, 12) est un silicium monocristal (100) ou orienté (110) ou un silicium polycristal ou un semiconducteur de liaison.

9. Cellule solaire selon au moins la revendication 1, **caractérisée en ce que** les premières et/ou les deuxièmes zones (11, 22, 23, 24, 25, 26) sont texturées au moins en dehors des contacts ohmiques (4, 10, 16).

10. Cellule solaire selon au moins la revendication 1, **caractérisée en ce que** l'écart entre les contacts ohmiques (4, 10, 16) est plus grand que l'écart entre les deuxièmes zones (22, 24, 26) et le côté opposé à ces dernières (27, 28, 29) du substrat semiconducteur (1, 6, 12).

11. Cellule solaire selon au moins la revendication 10, **caractérisée en ce que** les contacts ohmiques (4, 10, 16) vu de dessus présentent une structure de doigts, l'écart entre les doigts étant de 1 mm à 5 mm avec une largeur de doigt de 50 $\mu$m à 300 $\mu$m.

12. Cellule solaire selon la revendication 2 en forme d'une cellule solaire à couche d'inversion en nitrure de silicium (20) avec des contacts MIS (6, 7, 8) opposés aux contacts ohmiques (10), **caractérisée en ce que** l'écart entre les couches métalliques (8) séquentielles disponibles des contacts MIS (6, 7, 8) est de jusqu'à 1/50, de préférence 1/20 à $\frac{1}{2}$ plus petit que celui entre les contacts ohmiques (10).

**13.** Cellule solaire selon la revendication 12, **caractérisée en ce que** l'écart entre les couches métalliques (8) se situe entre 50 µm et 1 mm et celui des contacts ohmiques (10) entre 1 mm et 5 mm.

**14.** Procédé pour la réalisation d'une cellule solaire mince selon la revendication 1, **caractérisée en ce que**

- sur un côté d'un disque de substrat semiconducteur est appliqué un masque déterminant les zones de contact ohmiques,
- les zones non recouvertes par la morsure du masque, sont enlevées jusqu'à l'épaisseur souhaitée du substrat semiconducteur, et que
- tout le côté du substrat semiconducteur est recouvert d'une couche de passivation.

**15.** Procédé selon la revendication 14, **caractérisée en ce que** un matériau électriquement conductible formant les contacts ohmiques est utilisé comme masque.

**16.** Procédé selon la revendication 14, **caractérisée en ce que** après la morsure des zones non recouvertes par le masque, le masque est enlevé et un matériau électriquement conductible est appliqué sur les zones morsurées pour former les contacts ohmiques.

**17.** Procédé selon la revendication 14, **caractérisée en ce que** les zones non recouvertes par les masques sont texturées de préférence simultanément avec la morsure.

**18.** Procédé selon la revendication 14, **caractérisée en ce que** comme substrat semiconducteur on utilise un silicium monocristal (100) ou orienté (110) et que la morsure se fait par un réactif d'attaque anisotrope tel que de l'hydroxyde de potassium ou d'éthylènediamine.

**19.** Procédé selon la revendication 14, **caractérisée en ce que** on utilise un silicium monocristal comme substrat semiconducteur et que la morsure se fait par des réactifs d'attaque isotropes.

**20.** Procédé selon la revendication 14, **caractérisée en ce que** la couche de passivation est appliquée sous une température entre 300 °C et 600 °C sur le substrat semiconducteur et/ou trempée dans cette gamme.

**21.** Procédé selon la revendication 20, **caractérisée en ce que** une couche réflectrice est appliquée sur la couche de passivation par métallisation sous vide ou par pulvérisation cathodique ou sous forme d'une feuille métallique.

**22.** Procédé selon la revendication 14, **caractérisée en ce que** la morsure de silicium polycristal comme substrat semiconducteur se fait par des réactifs d'attaque isotropes ou anisotropes.

FIG.1

FIG.2

FIG.3